Europäisches Patentamt

European Patent Office

Office européen des brevets

(11) Veröffentlichungsnummer: **0 227 184**
**A1**

(12) # EUROPÄISCHE PATENTANMELDUNG

(21) Anmeldenummer: **86202291.0**

(22) Anmeldetag: **16.12.86**

(51) Int. Cl.⁴: **H03K 23/56**

(30) Priorität: **21.12.85 DE 3545646**

(43) Veröffentlichungstag der Anmeldung:
**01.07.87 Patentblatt 87/27**

(84) Benannte Vertragsstaaten:
**DE FR GB IT**

(71) Anmelder: **Philips Patentverwaltung GmbH**
**Billstrasse 80**
**D-2000 Hamburg 28(DE)**
**DE**
Anmelder: **N.V. Philips' Gloeilampenfabrieken**
**Groenewoudseweg 1**
**NL-5621 BA Eindhoven(NL)**
**FR GB IT**

(72) Erfinder: **Hövelmann, Rainer**
**Wohldorfer Damm 87a**
**D-2000 Hamburg 65(DE)**

(74) Vertreter: **Poddig, Dieter et al**
**Philips Patentverwaltung GmbH Billstrasse**
**80 Postfach 10 51 49**
**D-2000 Hamburg 28(DE)**

(54) **Synchroner Vorwärts-Rückwärts-Binärzähler.**

(57) Bei einem bekannten Binärzähler mit D-Flipflops ist jedem Flipflop ein Verknüpfungsnetzwerk zugeordnet, das das Signal für den D-Eingang erzeugt. Darin werden verschiedene Gattertypen verwendet. Bei dem Aufbau eines Zählers in I²L-Technik ist die Realisierung verschiedener Gattertypen jedoch aufwendig, da unmittelbar nur NAND-Gatter realisiert werden können. Erfindungsgemäß wird daher ein besonderer Aufbau der bekannten Schaltungsanordnung in I²L-Technik angegeben, der sehr einfach ist und nur wenige Gatterlaufzeiten erfordert, so daß eine relativ hohe Schaltgeschwindigkeit erreichbar ist.

Fig.2

## "Synchroner Vorwärts-Rückwärts-Binärzähler"

Die Erfindung betrifft eine Schaltungsanordnung für einen synchronen Vorwärts-Rückwärts-Binärzähler mit über ein Richtungssteuersignal umschaltbarer Zählrichtung aus einer Kette von D-Flipflops, von denen jedem Flipflop zumindest von dem zweiten Flipflop in der Kette an ein eigenes Verknüpfungsnetzwerk zugeordnet ist, das mindestens ein erstes und ein zweites Zustandssignal empfängt, deren Werte von Zuständen der vorhergehenden Flipflops bestimmt sind, und das abhängig von diesen Zustandssignalen und dem Richtungssteuersignal dem D-Eingang des zugeordneten Flipflops entweder dessen nichtinvertiertes oder dessen invertiertes Ausgangssignal zuführt.

Eine derartige Schaltungsanordnung ist bekannt aus der japanischen Patentanmeldung 55-166701 (Veröffentlichungsnummer: 57-91034). Bei dieser bekannten Schaltungsanordnung enthält jedes Verknüpfungsnetzwerk zwei UND-Gatter, ein ODER-Gatter und ein Exclusiv-ODER-Gatter. Die Zustandssignale sind die Ausgangssignale der in der Kette vorhergehenden Flipflops, so daß die Anzahl der Zustandssignale von Stufe zu Stufe wächst und die UND-Gatter entsprechend mehr Eingänge aufweisen müssen. Dies führt bei längeren Zählern zu einem erheblichen Verdrahtungsaufwand und umfangreichen UND-Gattern, was bei Ausführung als integrierte Schaltung Schwierigkeiten hervorruft.

Für die Realisierung von Gattern und Flipflops sind verschiedene Techniken bekannt, z.B. die bipolare TTL-Technik oder die mit Feldeffekt-Transistoren arbeitende CMOS-Technik. Diese unterscheiden sich beispielsweise durch die Schaltgeschwindigkeit und insbesondere durch den Leistungsbedarf. Mit den genannten und weiteren bekannten Techniken bereitet es keine besonderen Schwierigkeiten, verschiedene Arten von Verknüpfungsgatter aufzubauen.

Eine gewisse Ausnahme in dieser Hinsicht stellt die I²L-Technik dar, bei der unmittelbar nur NAND-Gatter realisiert werden können. Andere Verknüpfungsgattertypen können davon abgeleitet werden, z.B. mit Hilfe von Invertern, jedoch stellt dies einen erheblichen Aufwand dar. Wenn also die eingangs genannte bekannte Schaltungsanordnung in I²L-Technik direkt realisiert werden soll, wird jedes Verknüpfungsnetzwerk sehr umfangreich.

Aufgabe der Erfindung ist es daher, eine Schaltungsanordnung der eingangs genannten Art anzugeben, die besonders einfach in I²L-Technik aufgebaut ist.

Diese Aufgabe wird erfindungsgemäß dadurch gelöst, daß bei Ausbildung aller D-Flipflops und der Verknüpfungsnetzwerke in I²L-Technik je ein Ausgang beider Seiten des zugehörigen Flipflops mit dem Eingang eines ersten bzw. eines zweiten Inverters verbunden ist, deren Ausgänge miteinander und mit dem D-Eingang verbunden sind, und daß beide Ausgänge des Flipflops außerdem mit den Ausgängen von zwei Paaren in Reihe geschalteter dritter und vierter bzw. fünfter und sechster Inverter verbunden sind, wobei der Eingang des einen der Paare von Invertern das erste Zustandssignal mit einem vorgegebenen binären Wert erhält, wenn alle vorhergehenden Flipflops im Zustand Eins sind, und der Eingang des anderen der Paare von Invertern das zweite Zustandssignal mit einem vorgegebenen binären Wert erhält, wenn alle vorhergehenden Flipflops im Zustand Null sind, und abhängig vom Wert des Richtungssteuersignals entweder gleichzeitig beide Inverter des einen Paares oder gleichzeitig beide Inverter des anderen Paares gesperrt sind.

Bei einem derartigen Aufbau werden die erforderlichen Verknüpfungsfunktionen mit besonders geringem Aufwand realisiert, da je Verknüpfungsnetzwerk nur wenige Inverter mit wenigen Ausgängen erforderlich sind. Bekanntlich werden in der I²L-Technik die Verknüpfungen durch die Verbindung von Ausgängen von Invertern realisiert. Dadurch entspricht ein Aufbau in I²L-Technik nicht immer ohne weiteres dem verknüpfungslogisch einfachsten Aufbau.

Die Erzeugung der Zustandssignale durch direkte Verknüpfung der entsprechenden Ausgangssignale der vorhergehenden Flipflops ist bei Verwendung der I²L-Technik schaltungstechnisch besonders einfach. Eine weitere Ausgestaltung der Erfindung ist daher dadurch gekennzeichnet, daß die beiden Zustandssignale für mindestens einen Teil der Verknüpfungsnetzwerke durch die Verbindung jeweils eines getrennten Ausgangs aller vorhergehenden Flipflops erzeugt ist. Auf diese Weise sind keine zusätzlichen Inverter erforderlich, sondern die Inverter in den Ausgängen der Flipflops müssen lediglich mehrere Ausgänge aufweisen.

Die Erzeugung der Zustandssignale in einem Verknüpfungsnetzwerk kann dagegen nach einer anderen Ausgestaltung auf einfache Weise dadurch erfolgen, daß ein weiterer Ausgang des mit dem nicht invertierten Ausgang des Flipflops verbundenen Inverters das erste Zustandssignal und die Verbindung eines weiteren Ausgangs des sechsten Inverters mit einem getrennten weiteren invertierten Ausgang des Flipflops das zweite Zustandssignal liefert. Auch hierbei sind keine weiteren Inverter erforderlich, sondern lediglich zusätzliche Ausgänge von bereits vorhandenen Invertern.

Ausführungsbeispiele der Erfindung werden nachstehend anhand der Zeichnung näher erläutert. Es zeigen:

Fig. 1 einen möglichen logischen Aufbau eines Verknüfungsnetzwerkes nach der Erfindung zusammen mit dem zugehörigen Flipflop,

Fig. 2 den Aufbau eines Verknüpfungsnetzwerkes in I²L-Technik,

Fig. 3 die Zusammenschaltung mehrerer Flipflops und zugehöriger Verknüpfungsnetzwerke bei Erzeugung der Zustandssignale direkt aus den Ausgangssignalen vorhergehender Flipflops,

Fig. 4 eine Abwandlung des Verknüpfungsnetzwerkes zur Erzeugung der Zustandssignale für das folgende Verknüpfungsnetzwerk,

Fig. 5 einen Ausschnitt aus einer Kette von Flipflops mit Verknüpfungsnetzwerken mit gemischter Erzeugung der Zustandssignale,

Fig. 6 eine andere Möglichkeit für den Aufbau des Verknüpfungsnetzwerkes nach der Erfindung in I²L-Technik.

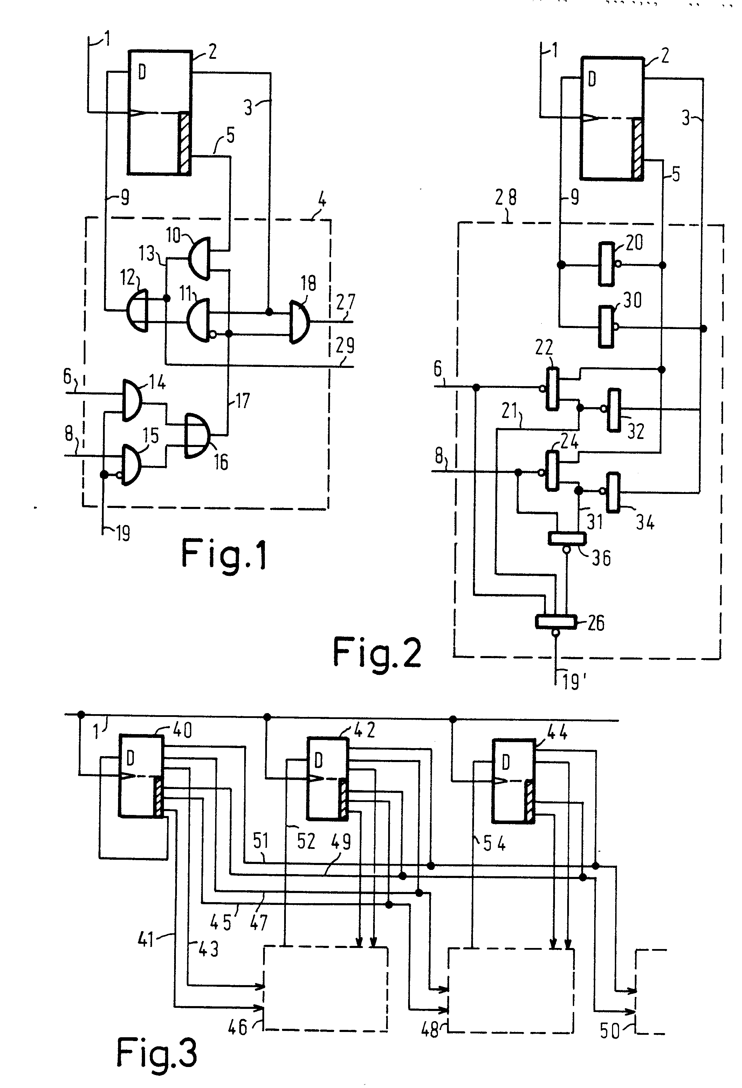

Dem Verknüpfungsnetzwerk 4 in Fig. 1 werden die Ausgangssignale beider Seiten des D-Flipflops 2 über die Leitungen 3 und 5 zugeführt sowie ferner zwei Zustandssignale über die Leitungen 6 und 8, von denen das Zustandssignal mit dem Wert "1" auf der Leitung 6 angibt, daß alle vorhergehenden Flipflops im Zustand Eins sind, und das zweite Zustandssignal mit dem Wert "1" auf der Leitung 8 angibt, daß alle vorhergehenden Flipflops gleichzeitig im Zustand Null sind. Ferner wird über die Leitung 19 das Richtungssteuersignal zugeführt, das für die Vorwärts-Zählrichtung den Wert "1" hat.

Das Flipflop 2 ist ein D-Flipflop mit der Eigenschaft, daß das über die Leitung 9 dem D-Eingang zugeführte Signal nach dem nächsten über den Takteingang 1 zugeführten Taktsignal auf die Ausgangsleitung 3 übertragen wird. Das Ausgangssignal auf der Leitung 5 ist invers zu dem Signal auf der Leitung 3.

Die Leitung 6 für das erste Zustandssignal ist mit dem einen Eingang eines UND-Gatters 14 verbunden, und die Leitung 8 für das zweite Zustandssignal ist mit dem einen Eingang eines UND-Gatters 15 verbunden. Über den jeweils anderen Eingang wird das UND-Gatter 14 durch einen Signalwert "1" für das Richtungssteuersignal auf der Leitung 19 freigegeben und gleichzeitig das UND-Gatter 15 gesperrt, wie durch den Kreis an dem letzteren Eingang angedeutet ist, während ein Signalwert "0" auf der Leitung 19 das UND-Gatter 14 sperrt und das UND-Gatter 15 freigibt. Die Ausgangssignale der beiden UND-Gatter 14 und 15 werden über das ODER-Gatter 16 zusammengefaßt und über die Leitung 17 weitergeleitet.

Die Leitung 5 für das invertierte Ausgangssignal des Flipflops 2 ist mit dem einen Eingang eines UND-Gatters 10 verbunden, und die Leitung 3 für das nicht invertierte Ausgangssignal des Flipflops 2 ist mit dem einen Eingang eines UND-Gatters 11 sowie mit dem einen Eingang eines Gatters 18 verbunden, das später erläutert wird. Der jeweils andere Eingang der beiden UND-Gatter 10 und 11 ist direkt bzw. invertiert mit der Leitung 17 verbunden, so daß ein Signalwert "1" auf der Leitung 17 das UND-Gatter 10 freigibt und das UND-Gatter 11 sperrt und umgekehrt. Die Ausgangssignale der UND-Gatter 10 und 11 werden über das ODER-Gatter 12 zusammengefaßt und über die Leitung 9 dem D-Eingang des Flipflops 2 zugeführt.

Solange beide Zustandssignale auf den Leitungen 6 und 8 niedrig sind, ist auch das Signal auf der Leitung 17 niedrig und damit das UND-Gatter 10 gesperrt und das UND-Gatter 11 freigegeben, so daß das nicht invertierte Ausgangssignal des Flipflops 2 auf der Leitung 3 über das UND-Gatter 11 und das ODER-Gatter 12 und die Leitung 9 dem D-Eingang des Flipflops 2 zugeführt wird und dieses bei einem Taktsignal auf der Leitung 1 seinen Zustand nicht ändert.

Wenn dagegen das erste Zustandssignal auf der Leitung 6 hoch ist, d.h. alle vorhergehenden Flipflops sind im Zustand Eins, und auch das Richtungssteuersignal auf der Leitung 19 ist hoch entsprechend der Vorwärtszählung, erscheint am Ausgang des UND-Gatters 14 ein hohes Signal, das über das ODER-Gatter 16 und die Leitung 17 das UND-Gatter 11 nunmehr sperrt und dafür das UND-Gatter 10 freigibt, so daß das invertierte Ausgangssignal des Flipflops 2 auf der Leitung 5 über das UND-Gatter 10 und das ODER-Gatter 12 und die Leitung 9 dem D-Eingang des Flipflops 2 zugeführt wird, so daß dieses mit dem nächsten Taktsignal auf der Leitung 1 seinen Zustand wechselt, wie dies für die Binärzählung erforderlich ist. Danach wird das erste Zustandssignal auf der Leitung 6 wieder niedrig, da die vorhergehenden Flipflops ebenfalls umschalten, und damit wird der vorher beschriebene logische Zustand wieder eingenommen, bei dem das Flipflop 2 seinen Zustand bei jedem folgenden Taktsignal auf der Leitung 1 beibehält.

Wenn das zweite Zustandssignal auf der Leitung 8 hoch ist, weil alle vorhergehenden Flipflops im Zustand Null sind, erscheint kein hohes Signal auf der Leitung 17 und erfolgt damit kein Zustandswechsel des Flipflops 2, weil das UND-Gatter 15 gesperrt ist. Wenn dagegen das Richtungssteuersignal auf der Leitung 19 niedrig ist, bewirkt ein hohes zweites Zustandssignal ein hohes Signal auf der Leitung 17, und in gleicher Weise wie vorstehend beschrieben erfolgt dann mit dem nächsten Taktsignal auf Leitung 1 ein Wechsel des Zustands des Flipflops 2, wie dies für die binäre Rückwärtszählung erforderlich ist.

Die beiden Zustandssignale auf den Leitungen 6 und 8 können von den vorhergehenden Flipflops durch unmittelbare Verknüpfung von deren entsprechenden Ausgangssignalen erzeugt werden. Eine andere Möglichkeit besteht darin, diese Zustandssignale durch das jeweils vorhergehende Verknüpfungsnetzwerk zu erzeugen, wie dies in Fig. 1 dargestellt ist. In dem Verknüpfungsnetzwerk 4 ist nämlich ein weiteres UND-Gatter 18 vorgesehen, dessen beide Eingänge mit der Leitung 3 für das nicht invertierte Ausgangssignal des Flipflops 2 und mit der Leitung 17 verbunden sind. Wenn alle dem dargestellten Flipflop 2 vorhergehende Flipflops im Zustand Eins sind, erscheint auf der Leitung 6 ein hohes Signal, und wenn das Richtungssteuersignal auf der Leitung 19 ebenfalls ein hohes Signal entsprechend Vorwärtszählung hat, wird über das UND-Gatter 14 und das ODER-Gatter 16 auf der Leitung 17 ein hohes Signal erzeugt. Wenn nun gleichzeitig auch das Flipflop 2 im Zustand Eins ist, führt auch die Leitung 3 ein hohes Signal, und das UND-Gatter 18 gibt richtig am Ausgang 27 ein hohes erstes Zustandssignal ab.

In entsprechender Weise erzeugt ein hohes Signal auf der Leitung 8 entsprechend alle vorhergehenden Flipflops im Zustand Null bei einem niedrigen Richtungssteuersignal auf der Leitung 19 ein hohes Signal auf der Leitung 17, und wenn gleichzeitig das Flipflop 2 im Zustand Null ist, führt die Leitung 5 ebenfalls ein hohes Signal, und damit erscheint am Ausgang 13 des UND-Gatters 10 ein hohes Signal, das als zweites Zustandssignal über den Ausgang 29 zum nächsten Netzwerk geführt wird. Für dieses zweite Zustandssignal ist also kein zusätzliches UND-Gatter erforderlich.

Die Fig 2 zeigt ein Verknüpfungsnetzwerk 28, das in I²L-Technik aufgebaut ist und die gleichen Funktionen ausführt wie das Netzwerk 4 nach Fig. 1, abgesehen von der Erzeugung der Zustandssignale für das folgende Netzwerk, das jedoch keine unmittelbare Übertragung der einzelnen logischen Verknüpfungen des Netzwerkes 4 nach Fig. 1 darstellt. Dies liegt an den besonderen Eigenschaften der I²L-Technik, mit der unmittelbar nur NAND-Gatter erzeugt werden können. Diese Technik verwendet nämlich Inverter in Form von Transistoren, in deren Basis ein Durchlaßstrom injiziert wird und die mehrere Kollektoren aufweisen können. Zur Bildung eines NAND-Gatters werden je ein Kollektor mindestens zweier verschiedener Transistoren zusammengeschaltet und mit der Basis eines weiteren Transistors verbunden, dessen Basisstrom über den Kollektor eines der zusammengeschalteten Transistoren abgeleitet wird, wenn dieser Transistor leitend ist. Dadurch ist der weitere Transistor gesperrt, wenn nur einer der zusammengeschalteten Transistoren leitend ist.

In Fig. 2 ist der Aufbau des D-Flipflops nicht näher dargestellt, jedoch führen Eingänge bei diesem Flipflop wie der Takteingang von der Leitung 1 und der D-Eingang von der Leitung 9 auf Basen von Transistoren, während Ausgänge wie die Ausgangsleitungen 3 und 5 Kollektoren von anderen Transistoren darstellen.

In dem Netzwerk 28 sind die die Inverter darstellenden einzelnen Transistoren vereinfacht als Blöcke dargestellt, deren Basiseingang durch einen Kreis markiert ist.

Bei Vorwärtszählung ist das Richtungssteuersignal auf der Leitung 19' der Fig. 2 niedrig, beispielsweise indem diese Leitung den Kollektor eines ansteuernden Transistors im leitenden Zustand darstellt, und damit ist der Transistor 26 gesperrt. Dies wiederum bedeutet, daß der Transistor 36 leitend ist und die auf den Leitungen 8 und 31 fliessenden Ströme ableitet, so daß die Transistoren 24 und 34 gesperrt sind. Wenn nun alle vorhergehenden Flipflops im Zustand Eins sind, erscheint auf der Leitung 6 ein hohes Signal, genauer gesagt wird der in die Basis des Transistors 22 injizierte Strom nicht abgeleitet, und da auch der Transistor 26 gesperrt ist, ist der Transistor 22 leitend und bringt die Leitung 5 auf ein niedriges potential, d.h. der Basisstrom des Transistors 20 wird abgeleitet, so daß dieser Transistor gesperrt ist. Außerdem wird durch den leitenden Transistor 22 der Transistor 32 gesperrt, so daß das Signal auf der Leitung 3 nur von dem Ausgang des Flipflops 2 bestimmt wird. Wenn das Flipflop 2 im Zustand Eins ist, ist das Signal auf der Leitung 3 hoch, der Transistor 30 ist leitend und das Signal auf der Leitung 9 und damit am D-Eingang des Flipflops 2 ist niedrig. Entsprechend ist beim Zustand Null des Flipflops 2 die Leitung 3 niedrig, der Basisstrom des Transistors 30 wird abgeleitet, so daß dieser gesperrt ist, und damit ist das Signal auf der Leitung 9 und am D-Eingang des Flipflops 2 hoch. Unter diesen angegebenen Bedingungen führt also die Leitung 9 stets ein zum Signal auf der Leitung 3 inverses Signal. Da das Signal am invertierenden Ausgang des Flipflops 2, d.h. das Signal auf der Leitung 5, wenn diese nicht durch einen anderen angeschlossenen Kollektor niedrig gemacht wird, invers zu dem Signal auf der Leitung 3 ist, erhält die Leitung 9 also das Signal des invertierten Ausgangs des Flipflops 2, wenn bei Vorwärtszählrichtung alle vorhergehenden Flipflops im Zustand Eins und damit die Leitung 6 hoch ist. Bei allen anderen Zuständen der vorhergehenden Flipflops ist die Letung 6 jedoch niedrig, damit der Transistor 22 gesperrt und der Transistor 32 leitend, so daß dann auf der Leitung 9 das inverse Signal der Leitung 5, also damit das Signal am nicht invertierten Ausgang des Flipflops erscheint.

Wenn das Signal auf der Richtungssteuerleitung 19' jedoch hoch ist entsprechend Rückwärtszählung, ist der Transistor 26 leitend, so daß die Transistoren 22 und 32 stets gesperrt sind, unabhängig vom Zustand der vorhergehenden Flipflops. Da nun aber auch der Transistor 36 gesperrt ist, kann auf der Leitung 8 ein hohes Signal auftreten, wenn alle vorhergehenden Flipflops im Zustand Null sind. Die Transistoren 24 und 34 arbeiten nun in gleicher Weise wie vorher beschrieben die Transistoren 22 und 32 bei Vorwärtszählung. Damit erfüllt also das Netzwerk 28 in Fig. 2 die gleiche logische Funktion wie das Netzwerk 4 in Fig. 1.

Die Erzeugung der Zustandssignale für die Eingänge 6 und 8 des Netzwerkes 28 in Fig. 2 kann durch direkte Verknüpfung von Ausgängen der vorhergehenden Flipflops erfolgen, wie in Fig. 3 dargestellt ist. Diese zeigt einen mehrstufigen Binärzähler mit einer Kette von D-Flipflops, von denen jedoch nur die ersten drei Flipflops 40, 42 und 44 der Kette dargestellt sind. Da das erste Flipflop 40 unabhängig von der Zählrichtung mit jedem Taktsignal auf der Taktleitung 1 seinen Zustand wechselt, ist dafür kein Verknüpfungsnetzwerk erforderlich, sondern einer der invertierten Ausgänge des Flipflops 40 ist direkt mit seinem D-Eingang verbunden. Für das zweite Flipflop 42 in der Kette ist ein Verknüpfungsnetzwerk 46 vorgesehen, das die Signale vom nicht invertierten und vom invertierten Ausgang des Flipflops 40 über die Leitungen 41 und 43 direkt als Zustandssignale erhält sowie die Signale von den beiden Ausgängen des zugehörigen Flipflops 42 selbst und das daraus das Signal auf der Leitung 52 für den D-Eingang des Flipflops 42 erzeugt. Der Eingang für das Richtungssteuersignal ist der Übersichtlichkeit halber weggelassen.

Entsprechend ist für das dritte Flipflop 44 in der Kette das Verknüpfungsnetzwerk 48 vorgesehen. Dies erhält die Zustandssignale über die Leitungen 45 und 47, die mit je einem invertierten bzw. einem nicht invertierten Ausgang der beiden Flipflops 40 und 42 verbunden sind, wodurch die Kombination der Zustände der Flipflops gebildet wird. Nur wenn beide Flipflops 40 und 42 im Zustand Null sind, ist in keinem dieser Flipflops der Ausgangstransistor für den invertierten Ausgang leitend, so daß von der Leitung 45 kein Strom abgeleitet wird und diese ein hohes Potential annehmen kann. In entsprechender Weise kann die Leitung 47 nur dann ein hohes Potential annehmen, wenn beide Flipflops 40 und 42 den Zustand Eins haben. Auf diese Weise sind für die Bildung der Zustandssignale für das Verknüpfungsnetzwerk 48 keine zusätzlichen Elemente erforderlich.

In entsprechender Weise werden die beiden Zustandssignale für das Verknüpfungsnetzwerk 50, das zu dem nicht mehr dargestellten vierten Flipflop der Kette gehört, auf den Leitungen 49 und 51 gebildet. Dabei sind an diese Leitungen Ausgänge von allen drei Flipflops 40, 42 und 44 angeschlossen. Auch in diesem Falle ist für die Bildung der Kombination der Zustände der Flipflops kein weiteres Element erforderlich. Dies gilt auch für weitere Verknüpfungsnetzwerke, wenn der Zähler noch mehr Stufen umfaßt. Es ist jedoch deutlich erkennbar, daß dann der Verdrahtungsaufwand beträchtlich anwächst, da für jede weitere Stufe des Zählers und damit für jedes weitere Verknüpfungsnetzwerk ein weiteres Leitungspaar von allen jeweils vorhergehenden Flipflops ausgehen muß, die in der dargestellten Weise verknüpft werden, wobei alle Flipflops entsprechende zusätzliche Ausgänge aufweisen müssen, die von einer bestimmten Anzahl an nicht mehr von jeweils einem Ausgangstransistor in den Flipflops gespeist werden können, so daß mehrere Ausgangstransistoren vorgesehen werden müssen. Dadurch wird der Aufbau längerer Zählketten sehr stark erschwert.

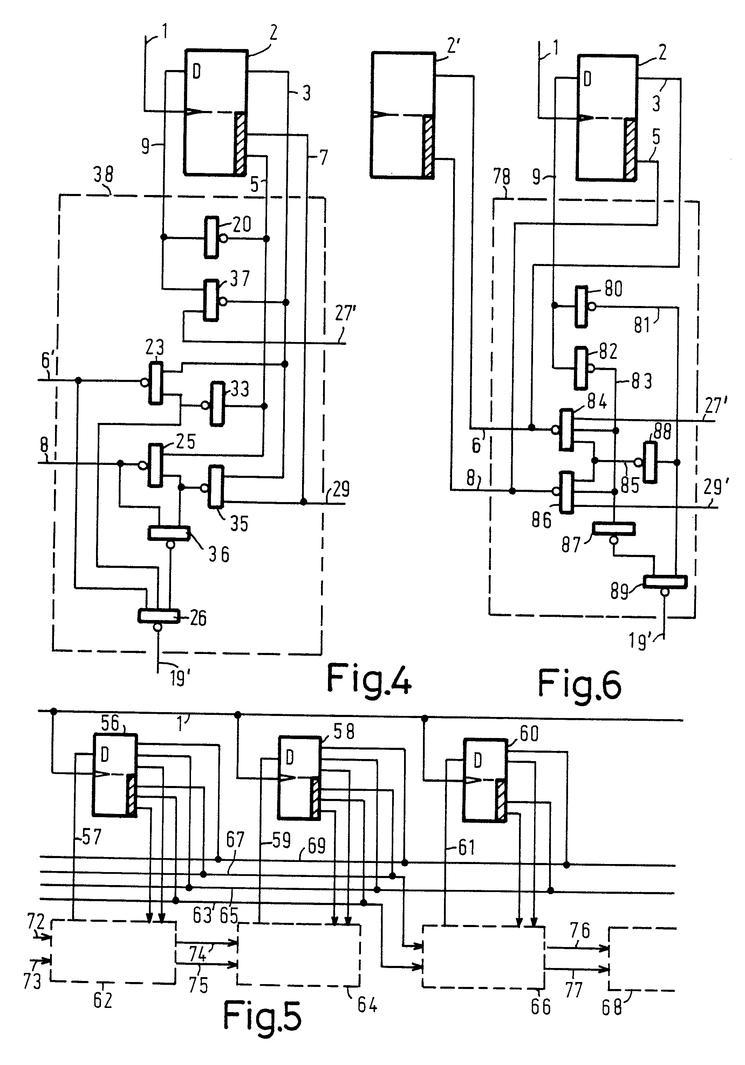

Ein Verknüpfungsnetzwerk, das die Zustandssignale für das jeweils folgende Verknüpfungsnetzwerk erzeugt, ist in Fig. 4 dargestellt. Damit ist ein vollständig modularer Aufbau auch längerer Zähler möglich. Der Aufbau des darin gezeigten Verknüpfungsnetzwerkes 38 stimmt im wesentlichen mit dem Aufbau des Verknüpfungsnetzwerkes 28 in Fig. 2 überein, wobei die Unterschiede nachfolgend erläutert werden. Wie bei der Fig. 2 beschrieben wurde, bestimmt bei einem Signal auf der Leitung 6, das alle vorhergehenden Flipflops gleichzeitig im Zustand Eins angibt, und bei einem Richtungssignal auf der Leitung 19' entsprechend Vorwärtszählung das Signal auf der Leitung 3 und damit das Ausgangssignal des Transistors 30 das Signal auf der Leitung 9. Daher wird der Transistor 30 aus Fig. 2 durch den Transistor 37 in Fig. 4 ersetzt, der einen zusätzlichen Ausgang 27' aufweist, der das erste Zustandssignal erzeugt. Wenn nämlich das Flipflop 2 den Zustand Eins hat, und alle vorhergehenden Flipflops haben ebenfalls den Zustand Eins, ist das Signal auf der Leitung 3 hoch und damit der Transistor 37 leitend, so daß nur unter dieser Bedingung das erste Zustandssignal am Ausgang 27' niedrig ist. Damit ist dieses Zustandssignal zwar eindeutig, jedoch invers zu dem Signal, das bei dem Netzwerk 28 in Fig. 2 angenommen wurde. Diese Invertierung läßt sich jedoch leicht berücksichtigen, da durch die beiden Transistoren 22 und 32 in Fig. 2 ohnehin beide Signalpolaritäten vorhanden sind. Die Invertierung wird dann wie in Fig. 4 dargestellt berücksichtigt, indem nunmehr der eine Ausgang des Transistors 23, der dem Transistor 22 in Fig. 2 entspricht, mit der Leitung 3 statt mit der Leitung 5 verbunden wird, und entsprechend ist der Ausgang des Transistors 33, der dem Transistor 32 in Fig. 2 entspricht, mit der Leitung 5 verbunden. Dadurch ist die Invertierung auf der Leitung 6' für das erste Zustandssignal in Fig. 4 berücksichtigt, so daß mehrere Verknüpfungsnetzwerke 38 in einer Kette zusammengeschaltet werden können.

Dies gilt auch für das zweite Zustandssignal für die folgende Stufe, das an einem Ausgang 29 des Verknüpfungsnetzwerkes 38 durch die Verbindung eines zusätzlichen Ausgangs 7 eines Transistors 35, der dem Transistor 34 in Fig. 2 entspricht, und eines zusätzlichen invertierten Ausgangs des Flipflops 2 gebildet wird. Wenn das Richtungssteuersignal auf der Leitung 19' hoch ist entsprechend Rückwärtszählung, ist der Transistor 26 leitend und damit der Transistor 36 gesperrt, so daß ein hohes Signal auf der Leitung 8, wenn alle vorhergehenden Flipflops im Zustand Null sind, den Transistor 25 leitend machen und damit den Transistor 35 sperren kann. Wenn dann auch gleichzeitig das Flipflop 2 im Zustand Null ist, leitet auch der Ausgang 7 keinen Strom ab, so daß am Ausgang 29 das zweite Zustandssignal hoch ist. Dieses Zustandssignal tritt zwar auch dann auf, wenn sich das Flipflop 2 im Zustand Null befindet, jedoch das Richtungs steuersignal auf der Leitung 19' niedrig ist entsprechend Vorwärtszählung, weil dann der Transistor 35 durch den dann leitenden Transistor 36 gesperrt wird. Dieses Zustandssignal wird jedoch in dem folgenden Verknüpfungsnetzwerk richt ausgewertet bzw. in dem Verknüpfungsnetzwerk 38 wird ein derartiges Zustandssignal am Eingang 8 von einem dem Verknüpfungsnetzwerk 38 vorhergehenden Verknüpfungsnetzwerk nicht ausgewertet, da dieses Signal auf der Leitung 8 über den leitenden Transistor 36 abgeleitet wird.

Bei dem Verknüpfungsnetzwerk 38 in Fig. 4 erscheint eine Signaländerung des Zustandssignals am Eingang 6' bei entsprechenden weiteren Signalbedingungen nach Durchlaufen der Transistoren 23 und 37 am Ausgang 27', und entsprechend erscheint eine Signaländerung des zweiten Zustandssignals am Eingang 8 bei entsprechenden anderen weiteren Signalbedingungen nach Durchlaufen der Transistoren 25 und 35 am Ausgang 29, d.h. in beiden Fällen nach Durchlaufen von nur zwei Transistoren. Diese Anzahl von zwei Transistoren ist auch das theoretische Minimum für die Durchführung der erforderlichen Verknüpfungen. Wenn jedoch eine längere Kette derartiger Verknüpfungsnetzwerke hintereinandergeschaltet ist, erhält das letzte Verknüpfungsnetzwerk in der Kette die Zustandssignale mit einer entsprechend großen Verzögerung, so daß die maximale Zählfrequenz dadurch begrenzt ist, denn nach einem Taktsignal, das die vorhergehenden Flipflops in der Kette in einen Zustand gestellt hat, nach dem das folgende Flipflop mit dem nächsten Taktsignal umschalten muß, darf dieses folgende Taktsignal erst erscheinen, wenn das Zustandssignal von der ersten Stufe die ganze Kette durchlaufen hat. Dieser Nachteil tritt bei der Anordnung nach Fig. 3 nicht auf, die jedoch einen erheblichen Verdrahtungsaufwand und damit bei Herstellung als integrierte Schaltung eine erhebliche Fläche auf dem Halbleiter beansprucht. Ein Kompromiß aus beiden Möglichkeiten ist bei der Anordnung nach Fig. 5 verwirklicht. Diese zeigt einen Ausschnitt mit den D-Flipflops 56, 58 und 60 aus einem längeren Binärzähler mit weiteren vorhergehenden und folgenden Stufen. Das Verknüpfungsnetzwerk 62 für das Flipflop 56 erhält die Zustandssignale über die Eingänge 72 und 73 und erzeugt außer dem Signal für den D-Eingang auf der Leitung 57 auch die Zustandssignale auf den Leitungen 74 und 75 für das folgende Verknüpfungsnetzwerk 64, das dem Flipflop 58 zugeordnet ist und das Signal für den D-Eingang auf der Leitung 59 erzeugt.

Das folgende Verknüpfungsnetzwerk 66 für das Flipflop 60 erhält jedoch die Zustandssignale nicht von dem vorhergehenden Verknüpfungsnetzwerk 64, sondern aus der direkten Verbindung der entsprechenden Ausgangsleitungen der vorhergehenden Flipflops über die Leitungen 63 und 67. Dieses Verknüpfungsnetzwerk 66 erzeugt außer dem Signal für den D-Eingang des Flipflops 60 auf der Leitung 61 auch die Zustandssignale für das folgende Verknüpfungsnetzwerk 68, für das das zugehörige Flipflop der Einfachheit halber weggelassen ist, auf den Leitungen 76 und 77. Der Binärzähler kann also als in Gruppen von Stufen bzw. Flipflops unterteilt betrachtet werden, wobei die Flipflops 56 und 58 eine Gruppe bzw. das Ende einer Gruppe und das Flipflop 60 den Anfang der folgenden Gruppe darstellt. Innerhalb jeder Gruppe werden die Zustandssignale von einem Verknüpfungsnetzwerk zum folgenden übertragen, und am Beginn einer Gruppe werden die Zustandssignale aus der direkten Verknüpfung der entsprechenden Ausgänge der vorhergehenden Flipflops gebildet. Diese so gebildeten Zustandssignale sind also nicht durch irgendwelche Stufen außerhalb der Flipflops selbst verzögert, während die Verzögerung der Zustandssignale innerhalb der Gruppen von deren Länge abhängt, wodurch die maximale Zählfrequenz bestimmt wird. Bei einer hohen geforderten Zählfrequenz können also nur wenige Stufen je Gruppe verwendet werden, so daß dann entsprechend mehr Gruppen entstehen.

Bei dem in Fig. 5 dargestellten Beispiel können die Flipflops 56 und 58 zum Ende der ersten Gruppe gehören, während das Flipflop 60 den Anfang der zweiten Gruppe darstellt. Darauf kann noch eine weitere Gruppe folgen, deren erstes Verknüpfungsnetzwerk die Zustandssignale über die Leitungen 65 und 69 empfängt. Dadurch sind bei der Aufteilung in drei Gruppen nur zwei Paare von Verbindungsleitungen erforderlich, von denen das eine Paar nur bis zum Ende der ersten Gruppe reicht, so daß der Verdrahtungsaufwand begrenzt bleibt, und dennoch läßt sich eine hohe Zählfrequenz erreichen.

Eine etwas einfachere Ausführung des Verknüpfungsnetzwerkes, das für die zweite Stufe eines Binärzählers verwendet werden kann, beispielsweise als Verknüpfungsnetzwerk 46 in Fig. 3, ist in Fig. 6 dargestellt. Darin sind die Eingänge 6 und 8 des Verknüpfungsnetzwerkes 78 für die beiden Zustandssignale direkt mit zwei entsprechenden Ausgängen des ersten Flipflops der Kette, das hier mit 2' bezeichnet ist, verbunden. Die Ausgangsleitungen 3 und 5 des zweiten Flipflops 2 der Kette sind in dem Verknüpfungsnetzwerk 78 direkt mit den entsprechenden Eingängen 6 und 8 für die Zustandssignale verbunden, die auf den Eingang je eines Invertertransistors 84 bzw. 86 führen. Je ein Ausgang beider Transistoren ist miteinander und mit der Leitung 85 verbunden, die auf den Eingang eines weiteren Transistors 88 führt. Je ein weiterer Ausgang der Transistoren 84 und 86 ist miteinander und mit der Leitung 83 verbunden, die auf den Eingang eines Transistors 82 führt. Der Ausgang des Transistors 88 ist über die Leitung 81 mit dem Eingang eines Transistors 80 verbunden. Die Ausgänge der Transistoren 80 und 82 sind miteinander und mit der Leitung 9 verbunden, die auf den D-Eingang des Flipflops 2 führt. Der Eingang 19' für das Richtungssteuersignal führt auf einen Transistor 89, dessen einer Ausgang mit der Leitung 81 und dessen anderer Ausgang über einen weiteren Invertertransistor 87 mit der Leitung 83 verbunden ist Die Transistoren 84 und 86 haben noch je einen weiteren Ausgang, der über den Ausgang 27' bzw. 29' als Zustandssignal für das Verknüpfungsnetzwerk der folgenden Stufe herausgeführt ist. Die Eingänge des ersten Flipflops 2' sind nicht näher dargestellt, da sie insbesondere ebenso wie die des Flipflops 40 in Fig. 3 geschaltet sein können.

Zunächst sei angenommen, daß das Richtungssteuersignal am Eingang 19' niedrig ist, so daß der Transistor 89 gesperrt ist, d.h. das Signal auf der Leitung 81 wird von dem Transistor 89 nicht beeinflußt, und andererseits ist dadurch der Transistor 87 leitend, d.h. die Leitung 83 ist in diesem Zustand ständig niedrig, so daß der Transistor 82 ständig gesperrt ist und das Signal auf der Leitung 9 nicht beeinflußt. Dadurch ist von den Eingängen 6 bzw. 8 nur ein Signalweg über die Transistoren 84 oder 86, den Transistor 88 und den Transistor 80 zur Leitung 9 möglich.

Wenn das Flipflop 2' den Zustand Null hat, ist das Signal am Eingang 6 stets niedrig und der Transistor 84 gesperrt. Das Signal am Eingang des Transistors 86 wird dagegen von dem invertierten Ausgangssignal des Flipflops 2 auf der Leitung 5 bestimmt, so daß unter diesen Bedingungen das Signal auf der Leitung 9 wegen der angegebenen dreifachen Invertierung das invertierte Signal der Leitung 5, d.h. das Signal der Leitung 3 ist, so daß das Flipflop 2 seinen Zustand mit einem Taktsignal auf der Leitung 1 nicht ändert. Wenn dagegen das Flipflop 2' im Zustand Eins ist, ist der Eingang 8 ständig niedrig und der Transistor 86 gesperrt und das Signal am Transistor 84 wird nur vom Signal auf der Leitung 3 bestimmt. Wegen der angegebenen dreifachen Invertierung ist damit das Signal auf der Leitung 9 am D-Eingang des Flipflops 2 gleich dem invertierten Ausgangssignal auf der Leitung 5, d.h. das Flipflop 2 ändert nach dem nächsten Taktsignal auf der Leitung 1 seinen Zustand.

Wenn das Signal am Richtungssteuereingang 19' jedoch hoch ist entsprechend Rückwärtszählung, ist der Transistor 89 leitend und hält das Signal auf der Leitung 81 ständig nedrig, wodurch der Transistor 80 ständig gesperrt ist, und außerdem ist der Transistor 87 dann gesperrt, so daß das Signal auf der Leitung 83 am Eingang des Transistor 82 von den Ausgängen der Transistoren 84 und 86 bestimmt wird. Damit liegt zwischen den Eingängen 6 bzw. 8 und der Leitung 9 nur eine zweifache Invertierung durch die Transistoren 84 oder 86 und den Transistor 82. Wenn das Flipflop 2' den Zustand Eins hat, führt der Eingang 8 niedriges Potential, wodurch der Transistor 86 gesperrt ist, und das Signal am Eingang des Transistors 84 wird durch das nicht invertierte Ausgangssignal des Flipflops 2 auf der Leitung 3 bestimmt. Durch die zweifache Invertierung ist dies auch das Signal auf der Leitung 9 am D-Eingang des Flipflops 2, so daß dieses seinen Zustand nicht wechselt. Erst wenn das Flipflop 2' den Zustand Null hat, wird der Transistor 84 gesperrt, und das Signal am Eingang des Transistors 86 wird durch das invertierte Ausgangssignal des Flipflops 2 auf der Leitung 5 bestimmt, das durch die zweifache Invertierung gleich dem Signal auf der Leitung 9 ist, so daß das Flipflop mit dem nächsten Taktsignal auf der Leitung 1 seinen Zustand ändert.

Bezüglich der Zustandssignale für das folgende Netzwerk an den Ausgängen 27' und 29' ist zu bemerken, daß der Transistor 84 nur dann leitend ist, wenn beide Flipflops 2' und 2 im Zustand Eins sind, und der Transistor 86 ist nur dann leitend, wenn beide Flipflops 2' und 2 im Zustand Null sind. Dadurch geben beide Ausgänge 27' und 29' das invertierte Zustandssignal für das folgende Netzwerk ab. Dieses folgende Netzwerk kann ähnlich wie das Netzwerk 38 in Fig. 4 aufgebaut sein, wobei lediglich die Verbindungen der Transistoren 25 und 35 mit den Leitungen 3 und 5 vertauscht werden müssen, d.h. der eine Ausgang des Transistors 25 wird mit der Leitung 3 verbunden und der eine Ausgang des Transistors 35 mit der Leitung 5. Der andere Ausgang des Transistors 35, der mit der Leitung 7 und dem Ausgang 29 verbunden ist, entfällt dann, und stattdessen erhält der Transistor 25 einen weiteren Ausgang, der mit der Leitung 7 und dem Ausgang 29 verbunden wird. Damit ist die Invertierung des zweiten Zustandssignals vollständig berücksichtigt.

**Ansprüche**

1. Schaltungsanordnung für einen synchronen Vorwärts-Rückwärts-Binärzähler mit über ein Richtungssteuersignal umschaltbarer Zählrichtung aus einer Kette von D-Flipflops, von denen jedem Flipflop zumindest von dem zweiten Flipflop in der Kette an ein eigenes Verknüpfungsnetzwerk zugeordnet ist, das mindestens ein erstes und ein zweites Zustandssignal empfängt, deren Werte von Zuständen der vorhergehenden Flipflops bestimmt sind, und das abhängig von diesen Zustandssignalen und dem Richtungssteuersignal dem D-Eingang des zugeordneten Flipflops entweder dessen nichtinvertiertes oder dessen invertiertes Ausgangssignal zuführt,

dadurch gekennzeichnet, daß bei Ausbildung aller D-Flipflops und der Verknüpfungsnetzwerke in I²L-Technik je ein Ausgang (3, 5) beider Seiten des zugehörigen Flipflops (2) mit dem Eingang eines ersten bzw. eines zweiten Inverters (20, 30; 37) verbunden ist, deren Ausgänge miteinander und mit dem D-Eingang (9) verbunden sind, und daß beide Ausgänge (3, 5) des Flipflops (2) außerdem mit den Ausgängen von zwei Paaren in Reihe geschalteter dritter und vierter bzw. fünfter und sechster Inverter (22, 32, 24, 34; 23, 33, 25, 35) verbunden sind, wobei der Eingang (6) des einen der Paare von Invertern (22, 32; 23, 33) das erste Zustandssignal mit einem vorgegebenen binären Wert erhält, wenn alle vorhergehenden Flipflops im Zustand Eins sind, und der Eingang (8) des anderen der Paare von Invertern (24, 34; 25; 35) das zweite Zustandssignal mit einem vorgegebenen binären Wert erhält, wenn alle vorhergehenden Flipflops im Zustand Null sind, und abhängig vom Wert des Richtungssteuersignals entweder gleichzeitig beide Inverter des einen Paares oder gleichzeitig beide Inverter des anderen Paares gesperrt sind.

2. Schaltungsanordnung nach Anspruch 1, dadurch gekennzeichnet, daß die beiden Zustandssignale für mindestens einen Teil der Verknüpfungsnetzwerke (46, 48, 50; 66) durch die Verbindung jeweils eines getrennten Ausgangs (45, 47, 49, 51; 63, 67) aller vorhergehender Flipflops - (42, 44, 56, 58) erzeugt ist.

3. Schaltungsanordnung nach Anspruch 1, dadurch gekennzeichnet, daß ein weiterer Ausgang (27') des mit dem nicht invertierten Ausgang (3) des Flipflops (2) verbundenen Inverters (37) das erste Zustandssignal und die Verbindung eines weiteren Ausgangs des sechsten Inverters (35) mit einem getrennten weiteren invertierten Ausgang - (7) des Flipflops (2) das zweite Zustandssignal liefert.

Fig.1

Fig.2

Fig.3

Fig.4

Fig.6

Fig.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE JOURNAL OF SOLID-STATE CIRCUITS, Band SC-17, Nr. 4, August 1982, Seiten 671-676, New York, US; A. BAHRAMAN et al.: "A versatile function generator chip implemented in an I2L gate array" <br> * Abschnitt IV auf Seite 673; Figur 5, Inverter E und F * | 1 | H 03 K  23/56 |
| A | ELECTRO CONF. RECORD, Band 4, 24./26. März 1979, Seiten 1-6; M.P. TIMKO: "Linear compatible I2L" <br> * Figuren 3a, 3b * | 1 | |
| A | IBM TECHNICAL DISCLOSURE BULLETIN, Band 22, Nr. 5, Oktober 1979, Seiten 1898-1899, New York, US; R.M. HORNUNG: "Different ways to design up/down counters with MTL gates" <br> * gesamtes Dokument * | 1 | **RECHERCHIERTE SACHGEBIETE (Int. Cl.4)** <br><br> H 03 K  23/00 <br> H 03 K  23/40 <br> H 03 K  23/42 |
| D,A | PATENT ABSTRACTS OF JAPAN, Band 6, Nr. 173 (E-129)[1051], 7. September 1982; & JP - A - 57 91034 (HITACHI SEISAKUSHO) 07.06.1982 | 1 | H 03 K  23/50 <br> H 03 K  23/56 |

Der vorliegende Recherchenbericht wurde für alle Patentansprüche erstellt.

| Recherchenort | Abschlußdatum der Recherche | Prüfer |
|---|---|---|
| BERLIN | 25-02-1987 | ARENDT M |